# EUROPÄISCHE PATENTSCHRIFT

(11) **EP 3 271 938 B1**
(45) Veröffentlichungstag und Bekanntmachung des Hinweises auf die Patenterteilung: **10.07.2024**
(21) Anmeldenummer: 16706510.1
(22) Anmeldetag: 15.02.2016
(51) Int. Cl.: H01L 21/60, H01L 23/488, B23K 26/20, H01L 21/67, H01L 23/49, H01L 23/485, H01L 23/48

(54) **VERFAHREN ZUR AUSBILDUNG EINER KONTAKTVERBINDUNG**
METHOD FOR FORMING A CONTACT CONNECTION
PROCÉDÉ SERVANT À RÉALISER UN RACCORDEMENT DE CONTACT

(30) Priorität: 16.03.2015 DE 102015103779
(43) Veröffentlichungstag der Anmeldung: 24.01.2018
(73) Patentinhaber: Pac Tech - Packaging Technologies GmbH, 14641 Nauen (DE)
(72) Erfinder: LÜDEKE, Heinrich, 40822 Mettmann (DE); GEELHAAR, Ricardo, 13591 Berlin (DE)
(74) Vertreter: advotec.
(86) Internationale Anmeldenummer: PCT/EP2016/053169
(87) Internationale Veröffentlichungsnummer: WO 2016/146323

(56) Entgegenhaltungen:
- EP-A2- 2 743 973
- DE-A1- 102005 034 485
- DE-A1- 102009 020 733
- JP-A- 2008 010 703
- US-A1- 2009 294 963
- EISELE R ET AL: "Reliable Chip Contact Joining", INTERNATIONAL CONFERENCE FOR POWER ELECTRONICS, INTELLIGENT MOTION AND POWER QUALITY PCIM, NÜRNBERG 13-15 MAY 2009,, 13 May 2009 (2009-05-13), pages 723 - 728, XP009178960, ISBN: 978-3-8007-3158-9

## Beschreibung

Die Erfindung betrifft ein Verfahren zur Ausbildung einer Kontaktverbindung zwischen einem Chip, insbesondere Leistungstransistor oder dergleichen, und einer Leitermaterialbahn, wobei die Leitermaterialbahn auf einem nicht leitenden Substrat ausgebildet wird, und wobei der Chip auf dem Substrat oder einer Leitermaterialbahn angeordnet wird, wobei jeweils auf einer Chipkontaktfläche des Chips und der Leitermaterialbahn eine Silberpaste oder eine Kupferpaste aufgebracht wird.

Die aus dem Stand der Technik bekannten Chips können mit einem Gehäuse oder auch als ein ungehäustes Halbleiter-Bauelement ausgebildet sein. Diese Chips werden dann regelmäßig auch als "die", "bare die" oder "bare chip" bezeichnet. Derartige Chips werden ohne Gehäuse weiterverarbeitet und unmittelbar auf einem Substrat bzw. einer Leiterplatte aufgebracht. Dabei können Chipkontaktflächen des Chips direkt mit Leitermaterialbahnen kontaktiert werden. Weitere Chipkontaktflächen des Chips können über Kontaktleiter bzw. sogenannte Bonddrähte mit weiteren Leitermaterialbahnen kontaktiert werden. Derartige Kontaktverbindungen werden regelmäßig auch an Leistungstransistoren ausgebildet.

Beispielsweise wird hier ein Leistungstransistor bzw. Chip mit einer unteren Chipkontaktfläche auf einer Leitermaterialbahn angeordnet und mit dieser im Wesentlichen vollflächig kontaktiert. Eine der kontaktierten unteren Chipkontaktfläche gegenüberliegende obere Chipkontaktfläche des Chips wird über eine Vielzahl von Bonddrähten mit einer weiteren, benachbart zum Chip verlaufenden Leitermaterialbahn durch beispielsweise Ultraschall-Bonden oder Löten verbunden. Durch diese Chipanordnung wird sichergestellt, dass ein ausreichend großer Leiterquerschnitt zur Übertragung hoher Ströme zur Verfügung steht. Auch können für derartige Anwendungsfälle vergleichsweise dicke Bonddrähte aus Aluminium eingesetzt werden.

Insbesondere bei Leistungstransistoren, wie MOSFET's, IGBT's und Dioden für Leistungsmodule, treten hohe thermische und elektrische Beanspruchungen, beispielsweise in einem Leistungsbereich von 15 bis 150 KW, auf. Diese Beanspruchungen können leicht zu einem Bauteilversagen der Kontaktverbindung bzw. der Chipanordnung führen. Darüber hinaus kann ein Einsatz der Chipanordnung in beispielsweise Fahrzeugen oder Windkraftanlagen eine Lebensdauer der Chipanordnung infolge von starken Temperaturschwankungen noch weiter verkürzen. So kann es zu einem Bruch bzw. Lösen einer Kontaktverbindung durch diese Belastungen kommen. Weiter ist eine Lötverbindung von einem Kontaktleiter mit einer Leitermaterialbahn bzw. einer Chipkontaktfläche nur auf eine Temperatur von maximal 175 °C erwärmbar, ohne dass die Kontaktverbindung einen bleibenden Schaden davonträgt. Weiter ist eine Herstellung einer derartigen Chipanordnung vergleichweise kostenaufwendig, da eine Vielzahl von Kontaktleitern zwischen der Chipkontaktfläche und der Leitermaterialbahn zur Übertragung der hohen Ströme angeordnet werden muss.

Die DE 10 2005 034 485 A1 offenbart ein Verbindungselement für ein Halbleiterbauelement und ein Verfahren zu dessen Herstellung, wobei ein Bonddrahtstück auf einer Bondfläche eines Halbleiterleistungschips fixiert und nachfolgend mit einer zu sinternden Metallpaste benetzt wird. Zur Fixierung des Bonddrahtstücks vor dem Sintern der Metallpaste wird ein Bonddraht unter einen Bondstichel geführt und mit einem Thermosonic-Kompressionsvorgang auf der Bondfläche befestigt.

Aus der DE 10 2009 020 733 A1 ist ein Verfahren zur Ausbildung einer Kontaktverbindung an einem so genannten Leistungsmodul bekannt, wobei Litzenbänder einer Flechtband-Kontaktleitung mit nasser Silber-Sinterpaste an Endbereichen benetzt werden. Nach dieser Tauchbenetzung erfolgt eine Trocknung der Silberpaste und danach ein Sintern bzw. Kontaktieren des Flechtbands mit einem Substrat des Chips oder einer Leitermaterialbahn mittels eines beheizbaren Stempels. Alternativ kann auch vorgesehen sein, das Flechtband im nassen Zustand zu sintern.

Die EP 2 743 973 A2 offenbart eine Chipanordnung, wobei hier ein Halbleiter auf einer Leiterbahn eines Substrats angeordnet wird. Eine Oberseite des Halbleiters ist mit einer Sintermetallschicht aus Silber versehen. Auf die Sintermetallschicht wird ein Bonddraht oder - Bändchen - aufgelegt und mittels eines Lasers mit der Sintermetallschicht verschweißt. Die Sintermetallschicht ist hier bereits ausgebildet, bevor der eigentliche Vorgang der Kontaktierung mittels des Lasers erfolgt.

Die US 2009/0294963 A1 zeigt einen Leistungstransistor, der mittels Kontaktleiter kontaktiert ist. Eine Metallpaste kann auf den Kontaktleiter appliziert sein, wobei der Kontaktleiter unter Ausübung einer Kraft auf den Kontaktleiter mit einem Chip verbunden wird. Auf dem Chip ist dabei eine Sintermetallschicht ausgebildet. Weiter kann die Metallpaste Silber-, Gold- oder Kupferpartikel enthalten.

Der vorliegenden Erfindung liegt daher die Aufgabe zugrunde, eine Chipanordnung mit einer Kontaktverbindung sowie ein Verfahren zur Ausbildung einer Kontaktverbindung vorzuschlagen, bei der bzw. dem die Kontaktverbindung eine verbesserte Haltbarkeit bei gleichzeitig vereinfachter Herstellung aufweist.

Diese Aufgabe wird durch ein Verfahren zur Ausbildung einer Kontaktverbindung mit den Merkmalen des Anspruchs 1 gelöst.

Bei dem erfindungsgemäßen Verfahren zur Ausbildung einer Kontaktverbindung zwischen einem Chip, insbesondere Leistungstransistor oder dergleichen, und einer Leitermaterialbahn, wird die Leitermaterialbahn auf einem nicht leitenden Substrat ausgebildet, wobei der Chip auf dem Substrat oder einer Leitermaterialbahn angeordnet wird, wobei jeweils auf einer Chipkontaktfläche des Chips und der Leitermaterialbahn eine Silberpaste oder eine Kupferpaste aufgebracht wird, wobei ein Kontaktleiter in die Silberpaste oder die Kupferpaste auf der Chipkontaktfläche und in die Silberpaste oder die Kupferpaste auf der Leitermaterialbahn eingetaucht wird, wobei ein in der Silberpaste oder der Kupferpaste enthaltenes Lösungsmittel durch Erwärmen zumindest teilweise verdampft wird, wobei die Kontaktverbindung dadurch ausgebildet wird, dass die Silberpaste oder die Kupferpaste mittels Laserenergie gesintert wird.

Das Substrat kann aus Kunststoffmaterial oder einem keramischen Material ausgebildet sein, wobei zunächst auf dem Substrat Leitermaterialbahnen zur Verbindung von elektronischen Bauelementen bzw. Halbleiterbauelementen ausgebildet werden. Dies kann durch ein aus dem Stand der Technik hinlänglich bekannten Verfahren erfolgen. Der Chip wird nachfolgend unmittelbar auf dem nicht leitenden Substrat oder einer Leitermaterialbahn angeordnet. Wenn der Chip auf der Leitermaterialbahn angeordnet wird, wird er mit dieser elektrisch kontaktiert. Auf einer dem Substrat bzw. der Leitermaterialbahn abgewandten Oberseite des Chips ist zumindest eine obere Chipkontaktfläche zur Kontaktierung des Chips ausgebildet. Durch die Ausbildung der Kontaktverbindung wird die Chipkontaktfläche nun mit einer relativ zum Chip benachbarten Leitermaterialbahn bzw. einer weiteren Leitermaterialbahn mittels eines Kontaktleiters verbunden. Dazu wird zunächst auf der relativ zu dem Chip benachbarten Leitermaterialbahn eine flüssige bzw. pastöse Silberpaste oder Kupferpaste aufgebracht. Auch auf der oberen Chipkontaktfläche wird die Paste bzw. Metallpaste aufgebracht. Das Aufbringen der Paste kann automatisiert mittels eines Applikators erfolgen. Danach wird der Kontaktleiter in die Paste auf der Chipkontaktfläche und in die Paste auf der Leitermaterialbahn eingetaucht, jeweils so, dass der Kontaktleiter zumindest teilweise von der Paste umgeben ist. In der Silberpaste bzw. Kupferpaste ist ein Lösungsmittel enthalten, welches durch Erwärmen zumindest teilweise verdampft wird, was eine Volumenreduzierung der applizierten Paste zur Folge haben kann. Je nach Art der Erwärmung kann das Lösungsmittel durch Verdunsten oder Sieden verdampft werden. Die abschließende Ausbildung der Kontaktverbindung erfolgt durch Sintern der Silberpaste bzw. Kupferpaste durch Laserenergie bzw. Lasersintern. Dabei wird ein Laserstrahl direkt oder indirekt auf einen Bereich der Kontaktverbindung gerichtet. In der Silberpaste enthaltenes Silberpulver bzw. Silberpartikel verschmelzen bzw. versintern dann zumindest teilweise miteinander, so dass eine elektrische Verbindung von dem Kontaktleiter mit der Chipkontaktfläche bzw. der Leitermaterialbahn ausgebildet ist. Das Sintern der Kupferpaste erfolgt entsprechend. Ein Aufbringen der Silberpaste oder die Kupferpaste auf die Chipkontaktfläche, die Leitermaterialbahn und ggf. den Kontaktleiter sowie das nachfolgende Sintern kann parallel oder sequentiell erfolgen. Dabei ist es dann unerheblich, ob zuerst die Chipkontaktfläche oder zuerst die Leitermaterialbahn mit Paste versehen bzw. zuerst die Paste auf der Chipkontaktfläche oder zuerst die Paste auf der Leitermaterialbahn gesintert wird. Auch ist es möglich, zunächst einen Kontakt an der Chipkontaktfläche oder der Leitermaterialbahn fertig auszubilden, um nachfolgend zur Ausbildung des zweiten Kontakts die Paste aufzubringen und zu sintern.

Dadurch, dass anstelle eines Lots eine Silberpaste oder eine Kupferpaste zur Herstellung der Kontaktverbindung verwendet wird, wird die Kontaktverbindung wesentlich länger haltbar. Die gesinterte Paste ist gegenüber starken Temperaturschwankungen und hohen Betriebstemperaturen wesentlich unempfindlicher. Beispielsweise können mit gesinterter Silberpaste Betriebstemperaturen des Chips von bis zu 300 °C erreicht werden. Darüber hinaus ist es auch nicht mehr erforderlich eine hohe Anzahl von Kontaktverbindungen zwischen der Chipanschlussfläche und der Leitermaterialbahn auszubilden um hohe Ströme übertragen zu können. Das erfindungsgemäße Verfahren ist weitestgehend unabhängig von einem Querschnitt des Kontaktleiters, so dass eine Anzahl der Kontaktleiter bzw. der Kontaktverbindungen wesentlich verringert werden kann, wodurch die Chipanordnung insgesamt kostengünstiger herstellbar wird.

Als ein Kontaktleiter kann eine Litze, bevorzugt ein Litzenband, besonders bevorzugt eine Litze oder ein Litzenband aus Kupfer oder einer Kupferlegierung, verwendet werden. Eine Litze ist besonders flexibel, so dass gegenüber einem massiven Draht als Kontaktleiter keine Schub- oder Zugspannungen in den jeweiligen Kontakten auf der Chipkontaktfläche oder der Leitermaterialbahn, wie sie durch große Temperaturdifferenzen bewirkt werden können, auftreten können. Ein Litzenband weist gegenüber einem Draht bzw. Bonddraht einen vergleichweise großen Querschnitt auf, weshalb damit hohe Ströme übertragen werden können.

Auch kann die Litze von der Silberpaste oder Kupferpaste zumindest teilweise infiltriert werden. Durch das Eintauchen der Litze in die Paste kann die Paste bzw. können Silberpartikel oder Kupferpartikel in die Litze eindringen, so dass eine besonders innige Verbindung von Silberpartikeln bzw. Kupferpartikeln und Litze beim Sintern ausgebildet werden kann. Auch kann die Paste infolge einer Kapillarwirkung der Litze von dieser aufgenommen werden, so dass die Litze im Bereich der Chipkontaktfläche bzw. Leitermaterialbahn mit Silberpartikeln bzw. Kupferpartikeln ausgefüllt ist.

Weiter kann vorgesehen sein, dass je Chipkontaktfläche alleine eine Litze verwendet wird. Dies wird dadurch möglich, dass die Litze bzw. das Litzenband eine vergleichsweise große Breite aufweisen kann, die den Abmessungen der Chipkontaktfläche angenähert ist. Es ist dann nicht mehr erforderlich eine Mehrzahl von Kontaktleitern zu verwenden. Wenn nur eine Litze zur Verbindung von Chipkontaktfläche und Leitermaterialbahn eingesetzt wird, ist das Verfahren besonders schnell und damit kostengünstig ausführbar.

Die Silberpaste oder die Kupferpaste kann durch Anordnung des Substrats an bzw. auf einem Heizelement erwärmt werden. Das Substrat und damit die Leitermaterialbahn sowie die Chipkontaktfläche können dann soweit erwärmt werden, dass es zu einer Verdampfung des Lösungsmittels der Paste kommt. Damit kann auf eine Verwendung eines Ofens oder einer ähnlichen Einrichtung zur äußeren Erwärmung der Paste vollständig verzichtet werden.

Darüber hinaus kann vorgesehen sein, das Substrat mittels eines Spannmittels bei dem Erwärmen zu haltern. Das Substrat ist dann einerseits genau positionierbar und andererseits kann das Spannmittel ein Heizelement aufweisen bzw. selbst das Heizelement ausbilden. Dadurch wird eine Erwärmung der Silberpaste oder der Kupferpaste zum Verdampfen des Lösungsmittels noch weiter vereinfacht.

Im Rahmen des Verfahrens kann noch vor einem vollständigen Verdampfen des Lösungsmittels die Silberpaste oder die Kupferpaste gesintert werden. So kann eine vollständige Trocknung der Silberpaste bzw. Kupferpaste vor dem Sintern verhindert werden. Eine vollständig lösungsmittelfreie bzw. getrocknete Paste kann leicht durch den Trocknungsvorgang oder eine Bewegung bedingte Risse aufweisen, die einen Ausfall der Kontaktverbindung begünstigen können.

Der Kontaktleiter kann während des Sinterns mittels einer Andruckeinrichtung auf die Chipkontaktfläche und/oder die Leitermaterialfläche gedrückt werden. So kann ein besonders inniger Kontakt zwischen Kotaktleiter und Chipkontaktfläche bzw. Leitermaterialbahn ausgebildet werden. Weiter kann eine Bildung unerwünschter Risse während des Abkühlens der gesinterten Silberpaste oder Kupferpaste vermieden werden.

In einer weiteren Ausführungsform des Verfahrens kann der Kontaktleiter nach dem Sintern abgetrennt werden. Beispielsweise kann der Kontaktleiter auf einer Rolle oder Haspel bevorratet und der Chipkontaktfläche bzw. der Leitermaterialbahn automatisiert zugeführt werden. Dabei kann zunächst ein Ende des Kontaktleiters auf der Chipkontaktfläche platziert werden. Ein Abschnitt des Kontaktleiters kann auf der Leitermaterialbahn angeordnet werden oder umgekehrt. Nach dem Sintern der Silberpaste oder der Kupferpaste und der Ausbildung der Kontaktverbindung kann der Kontaktleiter an dem Abschnitt abgetrennt bzw. abgeschnitten werden, so dass wieder ein freies Ende des Kontaktleiters für eine Ausbildung einer weiteren Kontaktverbindung zur Verfügung steht.

Die Chipkontaktfläche kann durch Aufbringen eines Kupferbands auf eine Chipoberfläche ausgebildet werden. Die Chipoberfläche kann dann aus einem Halbleitermaterial, wie beispielsweise Silizium, ausgebildet sein. Durch das Aufbringen des Kupferbands kann eine Metallisierung der Chipoberfläche besonders einfach erfolgen. Das Kupferband kann dann auch eine Ausbildung des elektrischen Kontaktes mit dem Kontaktleiter erleichtern.

Darüber hinaus kann eine Kontaktmetallisierung auf der Leitermaterialbahn und/oder der Chipkontaktfläche aufgebracht werden. Die Kontaktmetallisierung kann vergleichweise dünn ausgebildet werden und eine Benetzbarkeit der Chipkontaktfläche bzw. der Leitermaterialbahn mit Silberpaste oder Kupferpaste bzw. geschmolzener Silber- oder Kupferpaste wesentlich verbessern.

Die Kontaktmetallisierung kann mittels physikalischer Gasphasenabscheidung (PVD), Sputterdeposition, Galvanisieren oder stromlosen Plattieren ausgebildet werden.

Die Kontaktmetallisierung kann aus Silber, Nickel, Kupfer, Gold, Palladium, Aluminium oder einer anderen Legierung einer dieser Metalle ausgebildet werden. Eine Kontaktmetallisierung aus beispielsweise Silber ist vergleichsweise dünn herstellbar und ermöglicht auch eine vergleichsweise bessere Stromdichteverteilung und eine besonders gute thermische Ableitung von Wärmeenergie, beispielsweise zur Kühlung des Chips. Darüber hinaus kann sich die Silberpaste oder die Kupferpaste beim Sintern gut mit dem Silber der Kontaktmetallisierung verbinden.

Das mit dem erfindungsgemäßen Verfahren herstellbare Erzeugnis kann eine Chipanordnung sein, für insbesondere Leistungstransistoren oder dergleichen, umfassend einen Chip, ein nicht leitendes Substrat mit einer darauf ausgebildeten Leitermaterialbahn und einen Kontaktleiter, wobei der Chip auf dem Substrat oder einer Leitermaterialbahn angeordnet ist, wobei jeweils auf einer Chipkontaktfläche des Chips und der Leitermaterialbahn eine Silberpaste oder eine Kupferpaste aufgebracht ist, wobei der Kontaktleiter in die Silberpaste oder die Kupferpaste auf der Chipkontaktfläche und in die Silberpaste oder die Kupferpaste auf der Leitermaterialbahn eingetaucht ist, wobei ein in der Silberpaste oder der Kupferpaste enthaltenes Lösungsmittel durch Erwärmen verdampft ist, wobei eine Kontaktverbindung dadurch ausgebildet ist, dass die Silberpaste oder die Kupferpaste mittels Laserenergie gesintert ist.

Hinsichtlich der vorteilhaften Wirkungen der Chipanordnung wird auf die Vorteilsbeschreibung des erfindungsgemäßen Verfahrens verwiesen. Weitere vorteilhafte Ausführungsformen der Chipanordnung ergeben sich aus den auf den Anspruch 1 rückbezogenen Unteransprüchen.

Nachfolgend werden bevorzugte Ausführungsformen der Erfindung mit Bezug auf die beigefügten Zeichnungen näher erläutert.

Es zeigen:
Fig. 1 eine schematische Schnittansicht einer ersten Ausführungsform einer Chipanordnung während eines Verfahrensschritts;
Fig. 2eine schematische Schnittansicht der Chipanordnung aus Fig. 1 nach einer Fertigstellung einer Kontaktverbindung;
Fig. 3eine schematische Schnittansicht einer zweiten Ausführungsform einer Chipanordnung;
Fig. 4eine schematische Schnittansicht einer dritten Ausführungsform einer Chipanordnung.

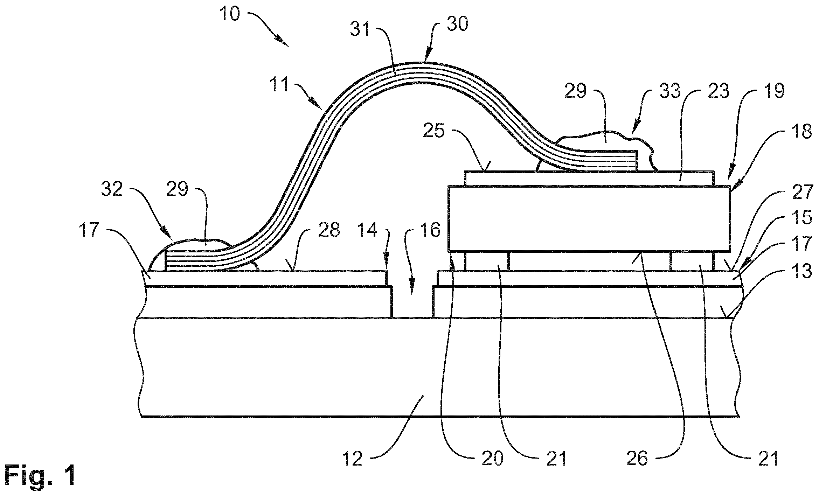

Die Fig. 1 zeigt eine Chipanordnung 10 in einer schematischen Schnittansicht während einer Herstellung einer Kontaktverbindung 11. Die Chipanordnung 10 umfasst ein nicht leitendes Substrat 12 auf dessen Oberfläche 13 eine Mehrzahl unterschiedlicher Leitermaterialbahnen 14 und 15 ausgebildet ist. Die Leitermaterialbahnen 14 und 15 sind über einen Isolierspalt 16 voneinander getrennt und somit elektrisch voneinander isoliert. Auf den Leitermaterialbahnen 14 und 15 ist jeweils eine Kontaktmetallisierung 17 aus Silber bzw. einer Silberlegierung ausgebildet bzw. aufgebracht. Die Kontaktmetallisierung 17 kann alternativ auch aus Nickel, Kupfer, Gold, Palladium, Aluminium oder einer anderen Legierung einer dieser Metalle ausgebildet sein. Auf der Leitermaterialbahn 15 ist ein Chip 18, der aus einem Halbleitermaterial ausgebildet ist, angeordnet. Auf einer der Leitermaterialbahn 15 abgewandten Rückseite 19 des Chips 18 ist eine Kontaktmetallisierung 23 aus Silber bzw. einer Silberlegierung und auf einer der Leitermaterialbahn 15 zugewandten Vorderseite 20 des Chips 18 sind Kontakthöcker 21 aufgebracht. Die Kontakthöcker 21 verbinden den Chip 18 mit der Leitermaterialbahn 15. Demnach sind an dem Chip 18 eine hintere Chipkontaktfläche 25 und eine vordere Chipkontaktfläche 26 ausgebildet. Der Chip 18 ist mit der Chipkontaktfläche 26 mit einer Leiteroberfläche 27 der Leitermaterialbahn 15 kontaktiert bzw. elektrisch verbunden. Auf einer Leiteroberfläche 28 der Leitermaterialbahn 14 und auf der Chipkontaktfläche 25 des Chips 18 ist jeweils eine definierte Menge Silberpaste 29 aufgebracht worden. Ein Kontaktleiter 30 ist als Litzenband 31 aus Kupfer ausgebildet und mit seinen jeweiligen Enden 32 und 33 in die Silberpaste 29 eingetaucht, so dass die Silberpaste 29 die Enden 32 bzw. 33 wesentlich umgibt.

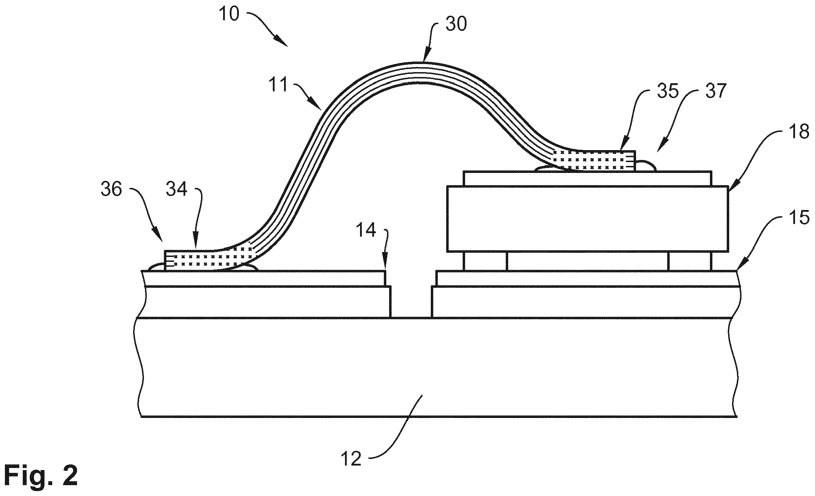

Wie aus **Fig. 2** zu ersehen ist, wurde die Silberpaste 29 nach einem überwiegenden Verdampfen des darin enthaltenen Lösungsmittels gesintert. Das Sintern erfolgte durch Einbringen von Laserenergie auf die Silberpaste 29 und die jeweiligen Enden 32 bzw. 33. So wurden auf der Leiteroberfläche 28 mit der Silberpaste 29 und dem Ende 32 ein erster Kontakt 34 und auf der Chipkontaktfläche 25 mit der Silberpaste 29 und dem Ende 33 ein zweiter Kontakt 35 der Kontaktverbindung 11 ausgebildet. Die nicht näher ersichtlichen Silberpartikel der Silberpaste 29 sind in jeweils die Enden 32 bzw. 33 eingedrungen und durch das Sintern miteinander versintert bzw. teilweise verschmolzen, wobei eine besonders innige Verbindung mit hier nicht näher ersichtlichen Filamenten des Litzenbands 31 und der Leiteroberfläche 28 bzw. Chipkontaktfläche 25 erfolgt ist. Die gesinterte Silberpaste 29 ist demnach in Kontaktbereichen 36 und 37 verfestigt.

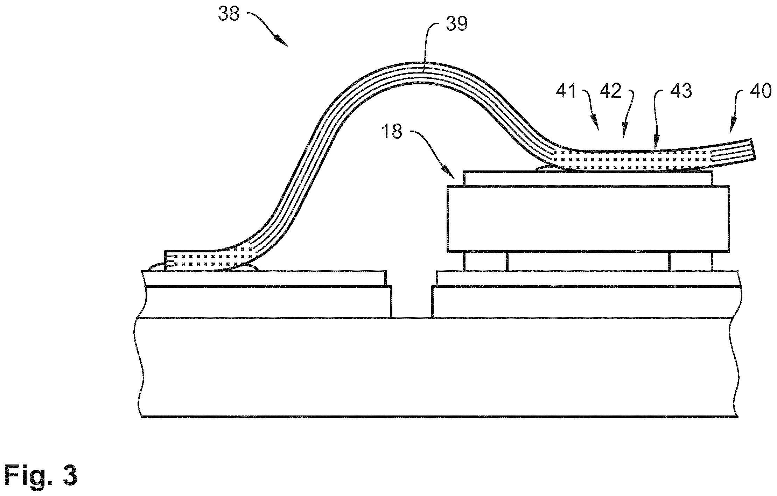

Die **Fig. 3** zeigt eine zweite Ausführungsform einer Chipanordnung 38, die im Unterschied zu der in der **Fig. 2** gezeigten Chipanordnung ein Litzenband 39 aufweist, das erst nach einem Sintern der Silberpaste 29 abgetrennt wurde. Ein Ende 40 des Litzenbands 39 steht daher aus einem Kontaktbereich 41 hervor, wobei ein Abschnitt 42 des Litzenbands 39 zur Ausbildung eines Kontakts 43 mit dem Chip 18 dient.

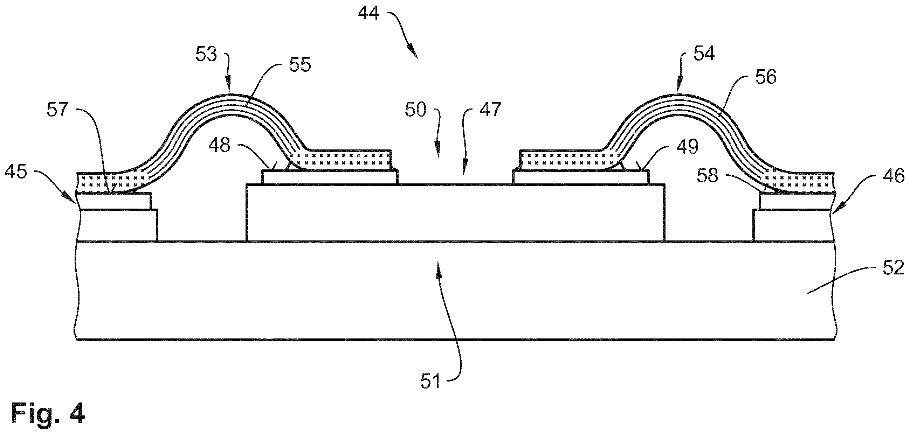

Die **Fig. 4** zeigt eine dritte Ausführungsform einer Chipanordnung 44, die im Unterschied zu der in **Fig. 2** gezeigten Chipanordnung Leitermaterialbahnen 45 und 46 aufweist, zwischen denen ein Chip 47 angeordnet ist. Der Chip 47 bildet zwei vordere Chipkontaktflächen 48 und 49 auf einer Vorderseite 50 des Chips 47 aus. Wobei der Chip 47 mit einer Rückseite 51 unmittelbar auf einem Substrat 52 angeordnet ist. Die Chipkontaktflächen 48 und 49 sind jeweils über Kontaktleiter 53 bzw. 54, die als Litzenband 55 bzw. 56 ausgebildet sind, mit Leiteroberflächen 57 bzw. 58 der Leitermaterialbahn 45 bzw. 46 verbunden.

Bei den vorstehend beschriebenen Ausführungsbeispielen kann auch die Silberpaste gegen Kupferpaste ausgetauscht sein.

## Patentansprüche

1. Verfahren zur Ausbildung einer Kontaktverbindung (11) zwischen einem Chip (18, 47) und einer Leitermaterialbahn (14, 45, 46), wobei die Leitermaterialbahn auf einem nicht leitenden Substrat (12, 52) ausgebildet wird, wobei der Chip auf dem Substrat oder einer weiteren Leitermaterialbahn (15) angeordnet wird, wobei jeweils auf einer Chipkontaktfläche (25, 48, 49) des Chips und der Leitermaterialbahn (14, 45, 46) eine Silberpaste (29) oder eine Kupferpaste aufgebracht wird,
und nach Aufbringung der Silberpaste (29) oder Kupferpaste ein Kontaktleiter (30, 53, 54) in die Silberpaste (29) oder die Kupferpaste auf der Chipkontaktfläche (25, 48, 49) und in die Silberpaste (29) oder die Kupferpaste auf der Leitermaterialbahn (14, 45, 46) eingetaucht wird, wobei ein in der Silberpaste (29) oder der Kupferpaste enthaltenes Lösungsmittel durch Erwärmen zumindest teilweise verdampft wird, wobei die Kontaktverbindung dadurch ausgebildet wird, dass die Silberpaste (29) oder die Kupferpaste mittels Laserenergie gesintert wird.

2. Verfahren nach Anspruch 1,
**dadurch gekennzeichnet,**
**dass** als ein Kontaktleiter (30, 53, 54) eine Litze verwendet wird.

3. Verfahren nach Anspruch 2,
**dadurch gekennzeichnet,**
**dass** die Litze von der Silberpaste (29) oder der Kupferpaste zumindest teilweise infiltriert wird.

4. Verfahren nach Anspruch 2 oder 3,
**dadurch gekennzeichnet,**
**dass** je Chipkontaktfläche (25, 48, 49) alleine eine Litze verwendet wird.

5. Verfahren nach einem der Ansprüche 2 bis 4,
**dadurch gekennzeichnet,**
**dass** als ein Kontaktleiter (30, 53, 54) eine Litze aus Kupfer oder einer Kupferlegierung verwendet wird.

6. Verfahren nach einem der Ansprüche 2 bis 5,
**dadurch gekennzeichnet,**
**dass** als ein Kontaktleiter (30, 53, 54) eine als Litzenband ausgebildete Litze verwendet wird.

7. Verfahren nach einem der vorangehenden Ansprüche,
**dadurch gekennzeichnet,**
**dass** die Silberpaste (29) oder die Kupferpaste durch Anordnung des Substrats (12, 52) an bzw. auf einem Heizelement erwärmt wird.

8. Verfahren nach einem der vorangehenden Ansprüche,
**dadurch gekennzeichnet,**
**dass** noch vor einem vollständigen Verdampfen des Lösungsmittels die Silberpaste (29) oder die Kupferpaste gesintert wird.

9. Verfahren nach einem der vorangehenden Ansprüche,
**dadurch gekennzeichnet,**
**dass** eine Kontaktverbindung (11) zwischen einem als Leistungstransistor ausgebildeten Chip (18, 47) und einer Leitermaterialbahn (14, 45, 46) ausgebildet wird.

## Claims

1. A method for forming a contact connection (11) between a chip (18, 47) and a conductor material track (14, 45, 46), the conductor material track being formed on a non-conductive substrate (12, 52), the chip being arranged on the substrate or on another conductor material track (15), a silver paste (29) or a copper paste being applied to each of a chip contact surface (25, 48, 49) of the chip and the conductor material track (14, 45, 46), and
a contact conductor (30, 53, 54) being immersed into the silver paste (29) or the copper paste on the chip contact surface (25, 48, 49) and into the silver paste (29) or the copper paste on the conductor material track (14, 45, 46) after the silver paste (29) or the copper paste has been applied, a solvent contained in the silver paste (29) or the copper paste being at least partially vaporized by heating and the contact connection being formed by sintering the silver paste (29) or the copper paste by means of laser energy.

2. The method according to claim 1,
**characterized in that**
a stranded wire is used as a contact conductor (30, 53, 54).

3. The method according to claim 2,
**characterized in that**
the stranded wire is at least partially infiltrated by the silver paste (29) or the copper paste.

4. The method according to claim 2 or 3,
**characterized in that**
only one stranded wire is used per chip contact surface (25, 48, 49).

5. The method according to any one of the claims 2 to 4,
**characterized in that**
a stranded wire made of copper or a copper alloy is used as a contact conductor (30, 53, 54).

6. The method according to any one of the claims 2 to 5,
**characterized in that**
a stranded wire formed as a flat litz wire is used as a contact conductor (30, 53, 54).

7. The method according to any one of the preceding claims,
**characterized in that**
heating of the silver paste (29) or the copper paste is achieved by arranging the substrate (12, 52) on or on top of a heating element.

8. The method according to any one of the preceding claims,
**characterized in that**
the silver paste (29) or the copper paste is sintered prior to complete vaporization of the solvent.

9. The method according to any one of the preceding claims,
**characterized in that**
a contact connection (11) is formed between a chip (18, 47) formed as a power transistor and a conductor material track (14, 45, 46).

## Revendications

1. Procédé servant à réaliser un raccordement de contact (11) entre une puce (18, 47) et une piste de matière conductrice (14, 45, 46), la piste de matière conductrice étant formée sur un substrat (12, 52) non conducteur, la puce étant disposée sur le substrat ou sur une autre piste de matière conductrice (15), une pâte d'argent (29) ou une pâte de cuivre étant appliquée sur une surface de contact de puce (25, 48, 49) de la puce ainsi que sur la piste de matière conductrice (14, 45, 46), et
un conducteur de contact (30, 53, 54) étant immergé dans la pâte d'argent (29) ou dans la pâte de cuivre sur la surface de contact de puce (25, 48, 49) et dans la pâte d'argent (29) ou dans la pâte de cuivre sur la piste de matière conductrice (14, 45, 46) après l'application de la pâte d'argent (29) ou de la pâte de cuivre, un solvant contenu dans la pâte d'argent (29) ou dans la pâte de cuivre étant vaporisé au moins partiellement par chauffage et le raccordement de contact étant formé en frittant la pâte d'argent (29) ou la pâte de cuivre par énergie laser.

2. Procédé selon la revendication 1,
**caractérisé en ce**
**qu'**un toron est utilisé comme conducteur de contact (30, 53, 54).

3. Procédé selon la revendication 2,
**caractérisé en ce que**
le toron est infiltré au moins partiellement par la pâte d'argent (29) ou par la pâte de cuivre.

4. Procédé selon la revendication 2 ou 3,
**caractérisé en ce que**
un seul toron par surface de contact de puce (25, 48, 49) est utilisé.

5. Procédé selon l'une quelconque des revendications 2 à 4,
**caractérisé en ce**
**qu'**un toron en cuivre ou en alliage de cuivre est utilisé comme conducteur de contact (30, 53, 54).

6. Procédé selon l'une quelconque des revendications 2 à 5,
**caractérisé en ce**
**qu'**un toron réalisé comme toron plat est utilisé comme conducteur de contact (30, 53, 54).

7. Procédé selon l'une quelconque des revendications précédentes,
**caractérisé en ce que**
la pâte d'argent (29) ou la pâte de cuivre est chauffée en plaçant le substrat (12, 52) sur un élément de chauffage.

8. Procédé selon l'une quelconque des revendications précédentes,
**caractérisé en ce que**
la pâte d'argent (29) ou la pâte de cuivre est frittée avant la vaporisation totale du solvant.

9. Procédé selon l'une quelconque des revendications précédentes,
**caractérisé en ce**
**qu'**un raccordement de contact (11) est formé entre une puce (18, 47) réalisée come transistor de puissance et une piste de matière conductrice (14, 45, 46).
